# EUROPEAN PATENT SPECIFICATION

(11) **EP 2 521 039 B1**
(45) Date of publication and mention of the grant of the patent: **16.10.2013**
(21) Application number: 11003744.7
(22) Date of filing: 06.05.2011
(51) Int. Cl.: G06F 13/40

(54) **Optical disc drive with USB interface**
Optisches Plattenlaufwerk mit USB-Schnittstelle
Commande de disque optique avec interface USB

(43) Date of publication of application: 07.11.2012
(73) Proprietor: Harman Becker Automotive Systems GmbH, 76307 Karlsbad (DE)
(72) Inventor: Loges, Matthias, 78073 Bad Dürrheim (DE)
(74) Representative: Grünecker, Kinkeldey, Stockmair & Schwanhäusser

(56) References cited:
- US-A1- 2008 253 254
- US-A1- 2009 165 028

## Description

### Field of the Invention

The present invention relates to a disc device for reproducing apparatuses of optical discs such as CD, DVD or BD. More particularly, the present invention relates to an optical disc drive for automotive use.

### Prior Art

In recent years, optical storage media have become widespread for use in both consumer electronics (CE) as well as computer technology. A particular field wherein optical discs are used is automotive systems. In a vehicle, optical discs may be used for both storing of AV (AudioNideo) data to be reproduced and storing of data to be transferred to vehicular equipment such as a navigation system.

At present, plural different kinds of optical storage media (optical discs) are used, which are known as, for instance, CD (compact disc), DVD (digital versatile disc), or BD (blu-ray-disc). In accordance with the capability of being recordable or rewriteable or respectively read-only, optical discs are further classified into categories, such as ROM (read-only-memory), R (recordable), RW (readable/writeable) or RAM (random access memory).

Devices capable of reading (such as for playback) and/or recording data from/on optical discs are equipped with drive units, into which the disc can be rotatably inserted. A pickup mechanism, based on laser technology is provided for reading/writing data from/on an optical disc inserted into the disc drive. Details of the mechanical construction as well as of the optical pickup system are well known in the art, and a description thereof is therefore herein omitted. The present invention is not limited to the exemplary types of optical discs mentioned above, but is applicable to all kinds of optical storage discs and respective disc drives that are available or will emerge in the future.

Specialized consumer electronics (CE) devices such as a CD-player or a DVD-recorder usually employ a so-called "single chip solution" for converting data read from an optical disc into reproducible data and, if desired, vice versa. Thereby, the CE device includes a specialized circuit, on a chip, which is capable of processing an input signal read from the CE or other optical disc by means of the pickup of the optical disc drive, so as to convert them into reproducible signals (such as, for instance, audio signals in the case of an audio CD). In view of the single chip solution, in these CE devices, no "interface" between the disc drive and the reproduction portion of the playback apparatus is internally necessary.

On the other hand, in multi-purpose applications such as those for computer systems, so-called ROM-drives are employed, which include an interface to a host (such as computer) that controls the operation of the disc drive as well as the processing of any data read out by the pickup of the disc drive.

For instance, internal optical disc drives of computers are conventionally connected with the host (i.e. the computer mainboard having a processor) by means of an interface according to a standard known as Advanced Technology Attachment (ATA). The ATA interface has been developed based on the interface IDE (Integrated Drive Electronics, further developed to EIDE - Enhanced IDE) originally introduced by Western Digital. A respective software protocol is known under the name of ATAPI (Advanced Technology Attachment with Packet Interface). These interfaces have been developed and are also employed for connecting other kinds of storage devices, besides optical disc drives, such as hard discs, solid-state drives or floppy drives, in computers. The originally developed ATA is now known under the designation "parallel ATA" (PATA). In contemporary systems, it has largely been replaced by serial ATA (SATA) interfaces.

On the other hand, ATA has the drawback of employing a rather complicated wire structure with 30 to 50 pins and is therefore less suitable for connecting external optical disc drives to a computer or laptop. Therefore, another interface standard has been developed, which is typically employed for connecting external optical disc drives: USB (universal serial bus). Although there are some other interfaces such as FireWire (IEEE 1394), or further developments of ATA such as eSATA (external SATA) and eSATAp (power over eSATA), USB has currently become the most widespread interface for external optical disc drives. It is a further particular advantage of USB that it enables the installation and removal of devices connected via USB without rebooting the computer (hot-swapping). A person skilled in the art is aware that USB has also been used as an interface for plural different kinds of other peripheral devices, such as USB mass-storage devices (flash drives), printers, scanners and others.

External drives connected to a host computer via USB have typically included some translating unit that provides a bridge between an interface of a drive such as SATA, PATA or others to a USB interface port.

Document US 2008/253254 A1 describes an optical disc drive comprising an additional USB interface for connecting a memory stick (employed, for instance, for storing audio or text data that shall be played back together with a video from an optical disc such as a DVD). The optical disc player is powered on, when a respective detector detects the presence of the memory stick.

Document US 2009/165028 A1 describes an optical disc drive of the slot-in type comprising a plurality of sensor switches in order to carefully supervise the insertion process of the disc. The supervision serves for automatically ejecting the disc when it may be jammed in the drive.

Optical disc drives for being used in vehicles generally have some specific features particularly adapting them for their intended use.

On the one hand, optical disc drives for vehicles should be compact in size because of the limited space available for installation. Therefore, automotive optical disc drives usually have a loading mechanism, operating without a laterally movable tray-like portion, known from CE or computer drives.

On the other hand, for reasons of power economy in a vehicle, it is desirable to activate the power consuming functions of the disc drive as well as of the host (called "head unit" in the vehicle) only when desired. The head unit is conventionally arranged near the driver's operation panel (dashboard) and comprises both a processor (central processing unit CPU), controlling *inter alia* the operation of the disc drive and the components of a vehicle entertainment and information system for which the disc drive is provided, as well as the respective operational elements by which a driver or other passengers sitting in the vehicle can operate the system.

Usually the central processing unit that controls all the decoding i.e. of the optical-disc-drive and that also controls all other function within the head unit like audio-streaming, navigation, source-switching etc. is supported by a more simple processing unit that among other things controls specific signals that allow to switch on the complete head unit thus activating also the central processing unit. This system is used to avoid high standby power consumption.

Moreover, operation should be particularly easy, without requiring the handling of plural specific steps, in order to be performed by a driver without excessively distracting him or her from controlling the vehicle. Therefore, automotive disc drives are usually arranged in such a way that the disc drive, as well as, if necessary, the head unit, are automatically activated upon the insertion of a disc. This is achieved by providing a particular mechanical switch, the so-called disc-in-switch, operated by a disc when inserted into the optical disc drive.

Conventionally, vehicular optical disc drives are fixedly mounted in the head unit. In view of the various different data to be communicated in a vehicle by employing a single drive, for example, AV data as well as information data for a navigation system, ROM drives are generally employed for automotive applications. Only ROM drives allow a direct data access for reading out ROM data such as for a navigation system. Moreover, in ROM drives the complete operation is controlled via the host processor (i.e. the CPU of the head unit in the vehicle). Thus, there is no need for a particular HMI (human machine interface) of the drive manufacturer, which leads to a cost decrease.

Conventional vehicular disc drives are usually connected to the head unit (host) via a parallel or serial ATA (PATA or SATA) interface, in a similar manner as described above for internal optical disc drives of a computer. In addition, an extra conductor is provided for connecting the disc-in-drive with the host via the SATA/PATA compatible plug so as to detect insertion of a disc into the optical disc drive. Such an extra wiring (additional to the standard PATA/SATA lines) is necessary for implementing the wake-up functionality of the host.

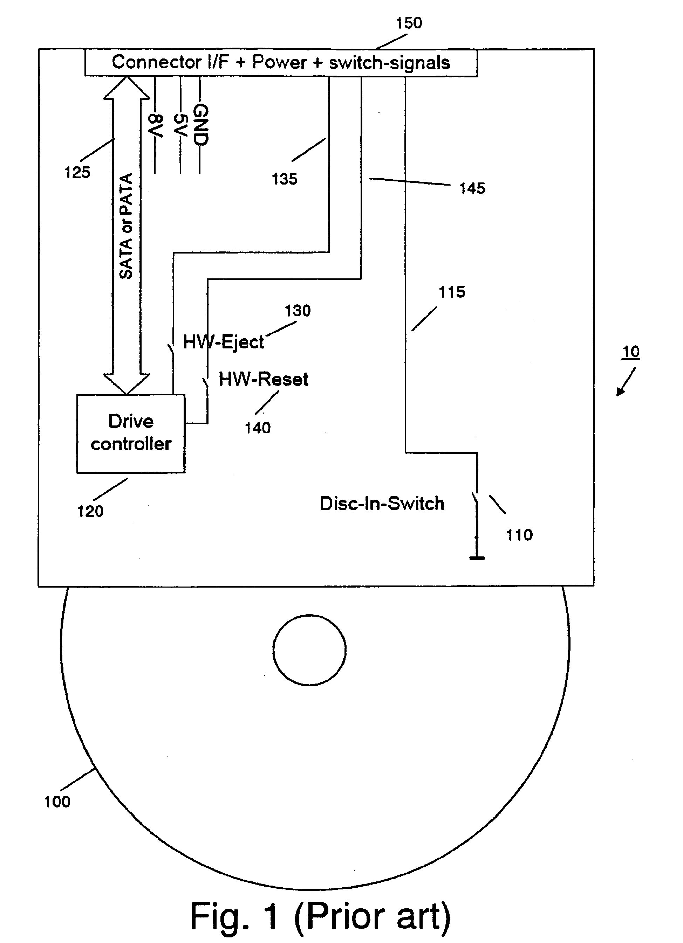

A schematic drawing of a prior art automotive optical disc drive 10 is illustrated in Fig. 1. The optical disc drive comprises a loading mechanism with a slot (not shown) for inserting an optical disc 100. A drive controller 120 controls the optical disc drive as well as the data communication between the optical disc drive and a host in accordance with the standard format of SATA or PATA (125). Physically, data communication is performed via a serial or parallel ATA connector interface 150. Via the same interface, the optical disc drive is also supplied with power from the head unit (cf. the lines marked "8V", "5V" and "GND"). The 8V power supply can be controlled to be switched off from the host. An extra line 115 including disc-in-switch 110 for detecting the presence of a disc in the optical disc drive is provided and connected to the head unit via connector 150. Further, connector 150 includes connections for extra lines 135 and 145 for providing particular signals to the drive controller 120 for Hardware Eject 130 and Hardware Reset 140. Hardware eject signal 130 is used in order to always be able to eject a disc in case of an error, independent of any current bus activity. Hardware reset signal 140 is employed in order to perform a hardware reset at the drive. Since both functions are controlled from the host processor (CPU) of the head unit, specialized signals are provided via extra lines 135 and 145, respectively.

It is a recent development in contemporary vehicles that the head units (HU) of vehicle entertainment and information systems have a decreasing size, and therefore nowadays there is insufficient space for arranging optical disc drives directly in the head unit. Moreover, it is no longer necessary to place the miniaturised head units in immediate proximity to the dashboard. Consequently, the optical disc drives arranged in the driver's proximity need to be connected to the head units over a longer distance. Typical distances for a connection between the disc drive and the head unit that may occur in a vehicle are, for instance, in the range of between 1.50 and 3.50 metres. However, serial or parallel ATA interfaces currently employed for vehicle optical disc drives are only partly or not at all suitable for this purpose. In view of the particular structure of PATA/SATA cables with a lot of (30 [SATA] to 50 [PATA]) pins, the signal quality decreases considerably with increasing transmission length. As a consequence, the desired transmission length in vehicles of up to several metres cannot be achieved with ATA based interfaces. This situation can also not be much improved by employing the further developments of ATA interfaces such as eSATA or eSATAp mentioned above.

A connection over distance could, in principle, be realised by employing USB, which is employed for connecting external computer disc drives. In order to access a PATA/SATA based optical disk drive via USB, a conversion circuit (PATA/SATA - USB Bridge IC) shall be employed.

In this case, however, the drawback arises that the USB interface does not provide the additional wiring 115 between disc-in-switch 110 and connector 150 of a conventional vehicular optical disc drive. Therefore, the disc-in recognition functionality of a conventional vehicular optical disc drive cannot be provided.

### Summary of the Invention

The present invention aims to provide an optical disc drive for a vehicle, which is connectable to a distant head unit, and at the same time enables an automatic activation upon the insertion of a disc.

This is achieved by the features of the independent claims.

According to a first aspect of the present invention, an optical disc drive for use in a vehicle is provided. The optical disc drive comprises a USB interface for connecting the optical disc drive with a head unit. The optical disc drive further comprises a disc-in-switch for detecting that an optical disc is inserted into the optical disc drive. Further, the optical disc drive comprises an internal power connection for providing power from a power connector of the optical disc drive to the USB interface and a connection switch for electrically connecting and disconnecting the internal power connection. The connection switch is controlled by the disc-in-switch so as to activate said USB interface upon the insertion of an optical disc.

According to a second aspect of the present invention, a method of activating an optical disc drive for use in a vehicle is provided. The optical disc drive is connected to a head unit via a USB interface. The method comprises the step of inserting an optical disc into the optical disc drive, thereby activating a disc-in-switch for detecting that an optical disc is inserted into the optical disc drive. The method further comprises the step of closing a connection switch of an internal power connection for providing power from a power connector of the optical disc drive to the USB interface. The connection switch is controlled by the disc-in-switch. The method further comprises the steps of activating said USB interface by closing the connection switch and of starting data communication between the optical disc drive and the head unit via the activated USB interface.

It is the particular approach of the present invention to provide an optical disc drive for being connected to a host via a USB interface having disc-in detection functionality. Thereby, usage of a USB interface for connecting an optical disc drive is possible in a vehicle where a disc detection function is desirable. The invention achieves the disc detection functionality by controlling a power connection switch for supplying the USB interface with power by means of a conventional disc-in-switch of an automotive optical disc drive.

Preferably, the optical disc drive further comprises a drive controller with a serial or parallel ATA interface and a conversion unit for signal conversion between the serial or parallel ATA interface and the USB interface. The power connector is connected to the conversion unit to provide the electrical disc drive with power. Power is supplied to the USB interface by means of the internal power connection connecting the USB interface to the conversion unit. The conversion unit enables the connection of the disc drive with a disk controller having a conventional ATA interface with a head unit via USB. The conversion unit is called "glue logic" and is more preferably realised by means of an FPGA (Field Programmable Gate Array). Alternatively, a specialised circuitry may be used for this purpose.

Also preferably, the internal power connection of the USB interface includes a line for providing a particular predetermined voltage to the USB interface and a line connected to ground (GND). According to a preferred embodiment, the predetermined voltage is 5V (Volt). The invention is, however, not limited to the above mentioned voltage. Other voltage values are equally possible within the scope of the present invention.

Preferably, the disc-in-switch further controls the connection switch so as to deactivate the USB interface when the optical disc is ejected from the optical disc drive. Since no data communication between the optical disc drive and the head unit is necessary when there is no disc in the disc drive, power consumption can thereby be reduced, without any additional control operations by the driver being necessary. As a consequence, the head unit detects that there is no active optical disc drive connected, and may thus also switch off power connection with the optical disc drive. More preferably, the activation upon ejection of an optical disc is delayed by a predetermined timeout. The timeout may be measured by a timer included in the optical disc drive. A deactivation timeout avoids a deactivation and subsequent reactivation in the case of another disc being inserted shortly after disc ejection, such as in a common disc change procedure.

Also preferably, the conversion unit further converts a command for emergency ejection of an optical disc received from the head unit via the USB interface into a Hardware Eject signal of the parallel or serial ATA interface of the drive controller. Also preferably, the conversion unit further converts a command for initiating a Hardware Reset of the optical disc drive received from the head unit via the USB interface into a hardware set signal of the parallel or serial ATA interface. Thereby a conventionally available Hardware Eject and/or Hardware Reset function, controlled by the host, can be provided for the optical disc drive connected via USB, although USB does not provide specialised electrical lines for those signals.

Preferably, the optical disc drive is a drive for reading any one of CD-, DVD-, or BD-discs, or combinations thereof.

Preferably also the head unit itself is activated from an inactive state, upon activating the USB interface. For instance, a disc may be inserted into the optical disc drive in a state where the vehicle radio apparatus and thus also the complete head unit are switched off. According to a preferred embodiment, the head unit is automatically activated when the disc is inserted, without desiring any further operational handling, possibly distracting the driver. The term "deactivated state" or closely related terms include any state in which the respective unit is not being actively operated, such as a switched-off state or a standby state.

Further preferably, the power supply to the drive controller of the optical disc drive is automatically activated upon activating the head unit. Thus activation of the USB interface serves to activate the whole optical disc drive via the head unit.

Further embodiments of the present invention are the subject matter of the dependent claims.

### Brief Description of the Drawings

Additional features and advantages of the present invention will become apparent from the following and more particular description as illustrated in the accompanying drawings, wherein:
Fig. 1 schematically illustrates the architecture of a conventional vehicular optical disc drive having a SATA or PATA interface,
Fig. 2 is a schematic illustration of a vehicular optical disc drive in accordance with an embodiment of the present invention
Fig. 3 is a flowchart illustrating a disc drive activation method in accordance with an embodiment of the present invention,

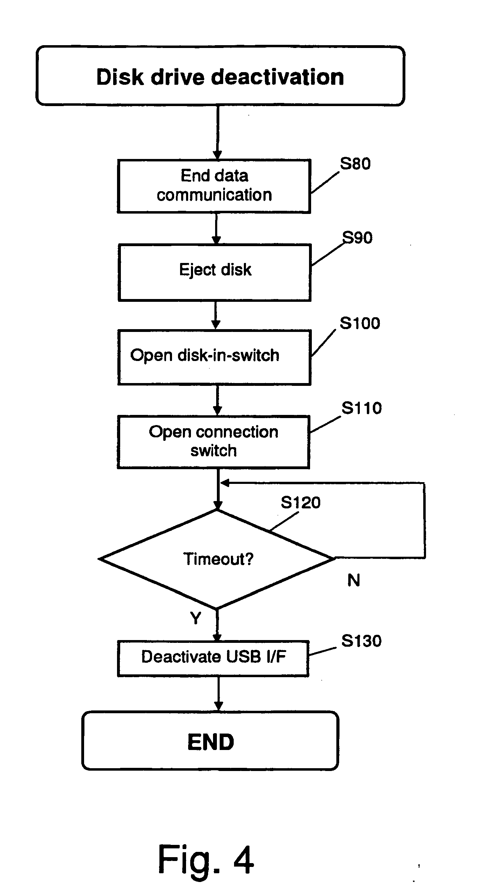

Fig. 4 is a flowchart illustrating automatic deactivation of an optical disc drive according to the present invention upon ejection of a disc, and
Fig. 5 is a flowchart showing Hardware Eject / Hardware Reset operations of an optical disc drive in accordance with the present invention.

### Detailed Description of the Invention

Illustrative embodiments of the present invention will now be described with reference to the drawings.

There exists a particular kind of optical disc drives (CD-/DVD-/BD-drives) having a so-called disc-in-switch. Disc-in-switches are particularly common in case of automotive optical disc drives. The disc-in-switch is operated as soon as a disc is inserted into the slot of the optical disc drive. With the help of the switch, the drive detects insertion of a disc.

Conventionally, the disc-in-drive is connected via a specific wire to a serial or parallel ATA interface between the optical disc drive and the host. For the detection, it is not necessary that the disc drive is provided with power. The host interrogates the status of the switch and as soon as a level change is detected, a wake-up process for the disc drive and preferably additionally for the complete head unit is started. In a vehicle head unit functioning as the host said interrogation functionality is preferably performed by the above mentioned additional simple processor that remains active while the CPU is in standby. Either power supply to the drive (8V) is switched on, or the head unit leaves the dormant or standby state and switches to the CD-DVD-/PD-drive as a source, or both.

Said functionality is not available if the optical disc drive is connected via a standard USB interface with the head unit, since there is no additional wire for the disc-in-signal generated by the disc-in-switch.

The present invention enables the host to detect insertion of a disc into a disc drive connected via USB and thus a wake-up for the host (head unit), without disconnecting/connecting the USB connection between the disc drive and the host, is possible.

Moreover, employing USB as an interface in an automotive disk drive enables a reduction of the necessary amount of hardware wirings. While ATA connectors have 30 to 50 pins, and additional lines are necessary for Disc-In, Hardware Eject and Hardware Reset signals, USB has only 4 pins.

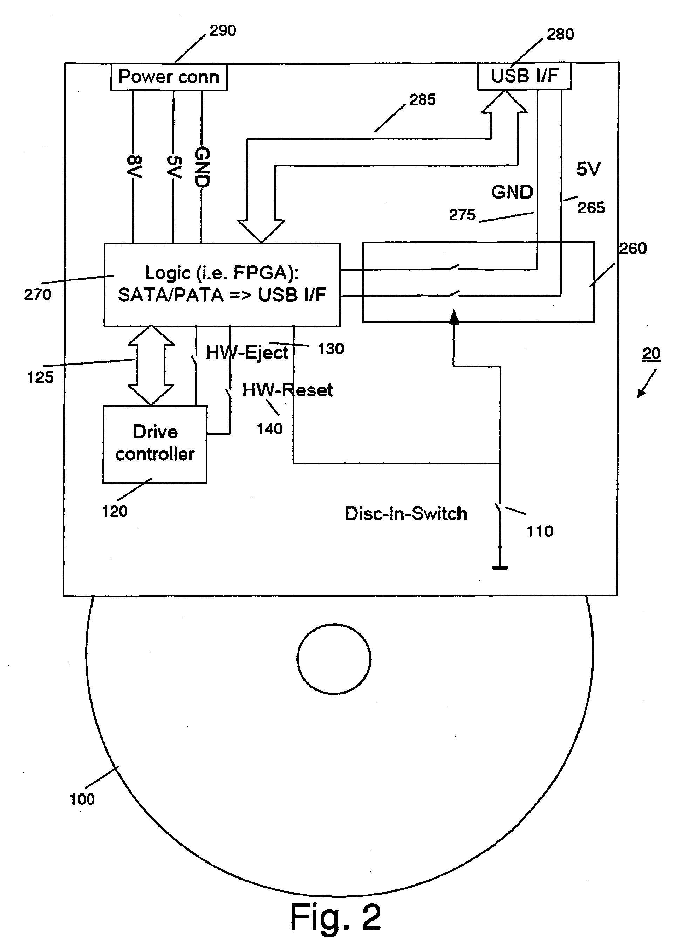

Fig. 2 is an overall scheme of an optical disc drive 20 in accordance with an embodiment of the present invention. In Fig. 2, the components which are the same as the respective components of the prior art optical disc drive illustrated in Fig. 1, have been designated with the same reference numerals. The overall mechanical structure, including a slot for inserting optical disc 100 and disc-in-switch 110 is the same as the in the prior art of Fig. 1. The disc drive further comprises drive controller 120 having a SATA /PATA interface 125 as well as the additional wirings for receiving Hardware Eject signal 130 and Hardware Reset signal 140. Thus, the aforementioned basic components of the optical disc drive have not been varied as compared to the prior art of Fig. 1.

The optical disc drive further comprises power connector 290, which provides the optical disc drive with an external power supply (preferably from the head unit) in a similar manner via connector 150 of Fig. 1. The power supply is illustrated by the electric lines labelled "8V", "5V" and "GND" designating supply voltages of 8V (Volt) and 5V and "ground", respectively. As conventionally, only the 8V supply can be controlled to be switched off from the host. The 5V power supply cannot be switched off from the host and is necessary for logic unit 270 (described below), in particular. It is further noted that the invention is not limited to the voltage values mentioned above. Other voltage supply values are equally applicable as desired. In particular, instead of the 5V power supply, a supply voltage of 3.3V is alternatively common.

The optical disc drive according to the invention comprises USB interface 280 for data communication with the head unit.

The central component of the optical disc drive 20 according to the embodiment of the invention is logic unit 270 ("glue logic"). It is the main task of glue logic 270 to perform data conversion between SATA /PATA interface 125 of drive controller 120, on the one hand, and USB interface 280 on the other hand, and vice versa. In Fig. 2, data communication is generally illustrated by means of wide double-sided arrows 125 illustrating communication between glue logic and drive controller in SATA /PATA format and 285 illustrating data communication between glue logic 270 and USB interface 280 in USB format. Moreover, logic unit 270 receives power from power connector 290 and distributes the power to the components of disc drive 20. In particular, there is an additional connection (illustrated by means of electric lines 265 and 275) between glue logic 270 and USB interface 280. Thereby, the "GND" and "5V" connections from the USB plug are connected to logic unit 270. The connection is provided via switch unit 260. In the illustrated embodiment, switch unit 260 comprises two separate switches for two connection lines. However, there may be a difference in the number of switches, as well as connection lines. It is only essential for the invention that there is at least one switch in a power connection line between USB interface 280 and logic unit (conversion unit) 270. Only when the switches (the switch) of switch unit 260 are closed, the glue logic 270 activates data traffic (285) over USB interface 280. As illustrated by means of arrow 115, switch unit 260 (in the illustrated embodiment: the switches for 5V and GND) is controlled via disc-in-switch 110. If a disc 100 is inserted into disc drive 20, disc-in-switch 110 is closed, and switch unit 260 is also controlled to be closed so that glue logic 270 controls USB interface 280 to be activated. If, on the other hand, by means of opening disc-in-switch 110, it is detected that no disc 100 is inserted into optical disc drive 20, switch unit 260 is controlled to open, and USB interface 280 is switched off (deactivated).

Thus, by means of switching the power supply of the USB interface, it is achieved that the interface is only activated, when a disk is inserted. On the other hand, the HotPlug capability of USB enables the host to automatically recognize the drive when the interface has been activated.

It has to be noted that the disc-in-switch 110 for automotive optical disc drives is implemented by means of a mechanical switch. Other types of detection means such as photo sensors, which may be employed in optical disc drives for detecting presence of a disc for other purposes, are not suitable, since in accordance with the purpose of the present invention, presence of the disc must be detected in a state where the optical disc drive is deactivated, and hence no power is supplied. In the latter situation, a photo-sensor based detector would not operate.

In addition, conversion unit 270 also receives the additional lines for providing Hardware Eject signal 130 and Hardware Reset signal 140 to the drive controller. Since no respective lines are provided for receiving those signals from the head unit in case of the USB interface 280, being employed for connecting the host unit, the latter lines end in the logic unit 270. Logic unit 270 provides hardware eject / reset signals, which are generated in the logic unit from respective commands, which are received from the head unit via USB interface 280 and the data communication path labelled 285 in Fig. 2.

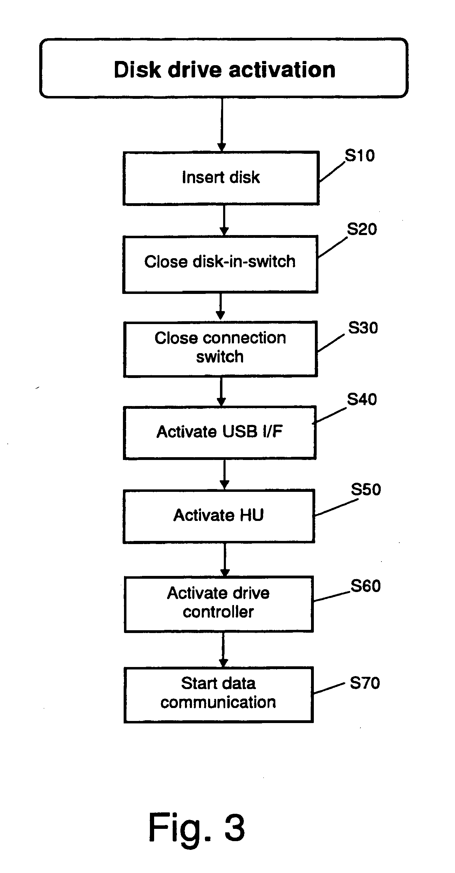

In the following, the processing flow of a method of optical disc drive activation in accordance with the present invention is described with reference to Fig. 3.

At the beginning, no disc is inserted. Hence, the switches of switching unit 260 are opened, and the host does not detect any device to be present at its USB interface.

The processing begins with inserting the disc 100 into a disc slot of the optical disc drive 20 (step S10). Thereby, disc-in-switch 110 is closed (step S20). Closed disc-in switch 110 controls switching unit 260 to establish the power connection between logic unit 270 and USB interface 280 (step S30). As a consequence, USB interface 280 is activated in step S40. Based on the HotPlug capability of the USB interface of the host, the host recognises that a device is connected via the USB interface. If the host (head unit) has been inactive before (in a standby state), the head unit becomes activated (step S50). Further, the drive controller 120 of optical disc drive 20 is activated at step S60 by initiating the provision of power (8V) via power connector 290 to establish the drive controller 120. When activation of all desired components is completed, glue logic 270 of disc drive 20 and the host of the head unit start data communication (step S70).

Vice versa, optical disc drive 20 will be deactivated when the disc is removed (ejected). Disc drive ejection is normally initiated by the user upon a respective operation (such as by pressing an eject button on the operation panel of the dashboard). As a consequence, data communication between disc drive 20 and the head unit ends (step S80) if it has not been finished before, for example, by having reached the end of an optical disc to be played back. Subsequently, the disc is ejected at step S90. Thereby, the mechanical disc-in-switch 110 is opened (step S100). As a consequence, connection switch unit 260 is controlled to be opened at step S110. Opening of connection switch 260 at step S110 initiate deactivation of USB interface 280 at step S130.

In accordance with a preferred embodiment, step S130 does, however, not immediately follow opening of connection switch 260 at step S110. Rather, deactivation of USB interface 280 can be delayed by a predetermined time ("timeout"). Therefore, in step S120 following immediately upon step S110, it is verified, whether a predetermined amount of time counted by a timer has been expired after connection switch unit 260 has been opened. As long as the predetermined time has not yet expired (S120: N), the USB interface remains active. Upon expiry of the predetermined time (S120: Y), the flow proceeds to step S130 and USB interface 280 is deactivated. By means of the timeout function, when the time period of the timeout is set to a reasonable value, it is avoided that the optical disc drive and the connected components are deactivated and re-activated in a situation such as disc change, wherein a switching into shut down or standby state is actually not intended.

It is an additional aspect of the present invention to enable the conventionally available Hardware Eject and Hardware Reset functions also in case of an automotive optical disc drive having a USB interface. Conventionally, Hardware Eject (emergency ejection) and Hardware Reset function are performed bv providing specialised switch signals via specific pins of the parallel or serial ATA connector 150 directly from the host processor to the drive controller (cf. lines 135 and 145 of Fig. 1). Those specialised lines are not available in case of data communication via USB. In order to enable the host-controlled hardware eject and hardware reset functionality also for an optical disc drive connected by USB, a disc drive according to an embodiment of the present invention enables a conversion of commands received via USB into the respective hardware signal to be forwarded to drive controller 120 having the standard serial or parallel ATA interface.

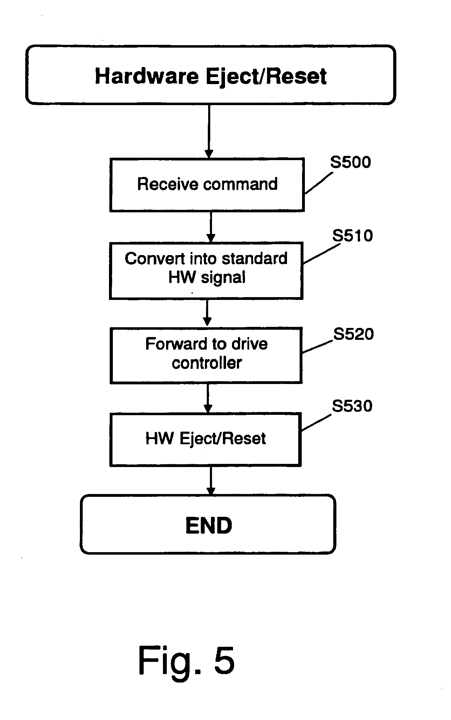

The particular processing of an exemplary embodiment is illustrated in the flowchart of Fig. 5.

The respective command from the head unit (eject or reset) is sent to the optical disc device via USB. Upon receiving the command (step S500), conversion unit 270 converts the command into the respective standard hardware signal at step S510. More particularly, glue logic 270 evaluates the received commands and generates a logical signal (130, 140) of high/low level (H/L signal) at specialised pins for this purpose. Via a specialised connection, the respective signals are forwarded to the drive controller, which receives the signals in the same manner as in the prior art automotive optical disc drive 10 of Fig. 1 (step S520). Subsequently, at step S530, disc controller 120 initiates Hardware Eject or Hardware Reset, depending on the particular signal received.

The present invention as defined by the independent claims is not limited to those particular embodiments that have been described in detail above. A person skilled in the art is aware of plural further modifications of the described embodiments. Although in automotive applications preferably disc drives for reading (reproducing) data only are employed, the invention is equally applicable to disc drives that are capable of both reading and recording.

In summary, the present invention provides an automotive optical disc drive, wherein data communication to a host is performed via USB and drive activation upon insertion of a disc is automatically performed by controlling power supply to the USB interface by means of a mechanical disc-in-switch. Thereby, the invention enables to maintain a specific functionality of automotive disc drives having parallel or serial ATA interfaces in case of data communication via USB. Moreover, the invention enables reducing the number of required hardware wirings.

## Claims

1. An optical disc drive for use in a vehicle, said optical disc drive comprising:
a USB interface (280) for connecting the optical disc drive with a head unit;
a disc-in-switch (110) for detecting that an optical disc (100) is inserted into the optical disc drive;
an internal power connection (265, 275) for providing power from a power connector (290) of said optical disc drive to said USB interface (280); and
a connection switch (260) for electrically connecting and disconnecting said internal power connection (265, 275);
wherein said connection switch (260) is controlled by said disc-in-switch (110) so as to activate said USB interface (280) upon insertion of an optical disc (100).

2. An optical disc drive according to claim 1, further comprising a drive controller (120) having a Serial or Parallel ATA interface (125); and
a conversion unit (270) for signal conversion between said Serial or Parallel ATA interface (125) and said USB interface (280);
wherein said power connector (290) is connected to said conversion unit (270) and said internal power connection (265, 275) connects said conversion unit (270) and said USB interface (280).

3. An optical disc drive according to claim 1 or 2, wherein said internal power connection (265, 275) includes a line (265) for providing a particular predetermined voltage to said USB interface (280) and a line (275) connected to ground.

4. An optical disc drive according to any of claims 1 to 3, wherein said disc-in-switch (110) further controls said connection switch (260) so as to deactivate said USB interface (280) upon ejection of the optical disc (100) from the optical disc drive.

5. An optical disc drive according to claim 4, wherein said deactivation upon ejection of an optical disc (100) is delayed by a predetermined timeout.

6. An optical disc drive according to any of claims 2 to 5, wherein said conversion unit (270) is further adapted to convert a command for emergency ejection of an optical disc (100) received from the head unit via said USB interface (280) into a Hardware Eject signal (130) of said Parallel or Serial ATA interface (125).

7. An optical disc drive according to any of claims 2 to 6, wherein said conversion unit (270) is further adapted to convert a command for initiating a hardware reset of said optical disc drive received from the head unit via said USB interface (280) into a Hardware Reset signal (140) of said Parallel or Serial ATA interface (125).

8. An optical disc drive according to any of claims 2 to 7, wherein said conversion unit (270) comprises an FPGA.

9. A method of activating an optical disc drive (20) for use in a vehicle, wherein said optical disc drive (20) is connected to a head unit via a USB interface (280), said method comprising the steps of:
inserting (S10) an optical disc (100) into said optical disc drive (20), thereby activating (S20) a disc-in-switch (110) for detecting that an optical disc (100) is inserted into the optical disc drive (20),
closing (S30) a connection switch (260) of an internal power connection (265, 275) for providing power from a power connector (290) of said optical disc drive (20) to said USB interface (280), said connection switch (260) being controlled by said disc-in-switch (110);
activating (S40) said USB interface (280) by closing (S30) said connection switch (260), and
starting (S70) data communication (285) between said optical disc drive (20) and said head unit via said activated USB interface (280).

10. A method according to claim 9, further comprising the step of activating (S50) said head unit from an inactive state, upon activating (S40) said USB interface (280).

11. A method according to claim 10, further comprising the step of activating (S60) a power supply to a drive controller (120) included in said optical disc drive (20) upon activating (S50) said head unit.

12. A method according to any of claims 9 to 11, further comprising the steps of
ejecting (S90) the optical disc (100) from the optical disc drive (20), and
deactivating (S130) said USB interface (280) upon ejection by opening (S110) said connection switch (260) under control of said disc-in-switch (110).

13. A method according to claim 12, wherein said deactivating step (S130) is delayed by a predetermined timeout (S120) with respect to the step (S90) of ejecting the optical disc (100).

14. A method according to any of claims 9 to 13, wherein said optical disc drive (20) further comprising a drive controller (120) having a Serial or Parallel ATA interface (125) and a conversion unit (270) for signal conversion between said Serial or Parallel ATA interface (125) and said USB interface (280); the method further comprising the steps of
receiving (S500) from the head unit via said USB interface (280) a command for emergency ejection of an optical disc (100), and
converting (S510) said command, in said conversion unit (270) into a Hardware Eject signal (130) of said Parallel or Serial ATA interface (125).

15. A method according to any of claims 9 to 14, wherein said optical disc drive (20) further comprising a drive controller (120) having a Serial or Parallel ATA interface (125) and a conversion unit (270) for signal conversion between said Serial or Parallel ATA interface (125) and said USB interface (280); the method further comprising the steps of
receiving (S500) from the head unit via said USB interface (280) a command for hardware reset of said optical disc drive (20), and
converting (S510) said command, in said conversion unit (270), into a Hardware Reset signal (140) of said Parallel or Serial ATA interface (125).

## Patentansprüche

1. Optisches Plattenlaufwerk zur Verwendung in einem Fahrzeug, wobei das optische Plattenlaufwerk Folgendes umfasst:
eine USB-Schnittstelle (280) zum Verbinden des optischen Plattenlaufwerks mit einer Haupteinheit;
einen Platteneinführschalter (110), der erkennt, dass eine optische Platte (100) in das optische Plattenlaufwerk eingeführt ist;
eine interne Leistungsverbindung (265, 275), um Leistung von einem Leistungsanschluss (290) des optischen Plattenlaufwerks an die USB-Schnittstelle (280) bereitzustellen; und
einen Verbindungsschalter (260) zum elektrischen Verbinden und Trennen der internen Leistungsverbindung (265, 275);
wobei der Verbindungsschalter (260) vom Platteneinführschalter (110) gesteuert wird, um die USB-Schnittstelle (280) beim Einführen einer optischen Platte (100) zu aktivieren.

2. Optisches Plattenlaufwerk nach Anspruch 1, ferner umfassend eine Laufwerksteuerung (120) mit einer seriellen oder parallelen ATA-Schnittstelle (125); und
eine Umwandlungseinheit (270) zur Signalumwandlung zwischen der seriellen oder parallelen ATA-Schnittstelle (125) und der USB-Schnittstelle (280);
wobei der Leistungsanschluss (290) mit der Umwandlungseinheit (270) verbunden ist und die interne Leistungsverbindung (265, 275) die Umwandlungseinheit (270) und die USB-Schnittstelle (280) verbindet.

3. Optisches Plattenlaufwerk nach Anspruch 1 oder 2, wobei die interne Leistungsverbindung (265, 275) eine Leitung (265) zum Bereitstellen einer bestimmten im Voraus festgelegten Spannung an die USB-Schnittstelle (280) und eine mit Masse verbundene Leitung (275) aufweist.

4. Optisches Plattenlaufwerk nach einem der Ansprüche 1 bis 3, wobei der Platteneinführschalter (110) ferner den Verbindungsschalter (260) derart steuert, dass die USB-Schnittstelle (280) beim Auswerfen der optischen Platte (100) aus dem optischen Plattenlaufwerk deaktiviert wird.

5. Optisches Plattenlaufwerk nach Anspruch 4, wobei die Deaktivierung beim Auswerfen einer optischen Platte (100) um eine im Voraus festgelegte Auszeit verzögert wird.

6. Optisches Plattenlaufwerk nach einem der Ansprüche 2 bis 5, wobei die Umwandlungseinheit (270) ferner dazu ausgebildet ist, einen Befehl zum Notauswurf einer optischen Platte (100), der von der Haupteinheit über die USB-Schnittstelle (280) empfangen wird, in ein Hardware-Auswurf-Signal (130) der seriellen oder parallelen ATA-Schnittstelle (125) umzuwandeln.

7. Optisches Plattenlaufwerk nach einem der Ansprüche 2 bis 6, wobei die Umwandlungseinheit (270) ferner dazu ausgebildet ist, einen Befehl zum Einleiten einer Hardware-Rücksetzung des optischen Plattenlaufwerks, der von der Haupteinheit über die USB-Schnittstelle (280) empfangen wird, in ein Hardware-Rücksetz-Signal (140) der seriellen oder parallelen ATA-Schnittstelle (125) umzuwandeln.

8. Optisches Plattenlaufwerk nach einem der Ansprüche 2 bis 7, wobei die Umwandlungseinheit (270) ein FPGA umfasst.

9. Verfahren zum Aktivieren eines optischen Plattenlaufwerks (20) zur Verwendung in einem Fahrzeug, wobei das optische Plattenlaufwerk (20) über eine USB-Schnittstelle (280) mit einer Haupteinheit verbunden ist, wobei das Verfahren folgende Schritte umfasst:
Einlegen (S10) einer optischen Platte (100) in das optische Plattenlaufwerk (20) und dadurch Aktivieren (S20) eines Platteneinführschalters (110), der erkennt, dass eine optische Platte (100) in das optische Plattenlaufwerk eingeführt ist (20);
Schließen (S30) eines Verbindungsschalters (260) einer internen Leistungsverbindung (265, 275) zum Bereitstellen von Leistung von einem Leistungsanschluss (290) des optischen Plattenlaufwerks (20) an die USB-Schnittstelle (280), wobei der Verbindungsschalter (260) von dem Platteneinführschalter (110) gesteuert wird;
Aktivieren (S40) der USB-Schnittstelle (280) durch Schließen (S30) des Verbindungsschalters (260), und
Starten (S70) von Datenübertragung (285) zwischen dem optischen Plattenlaufwerk (20) und der Haupteinheit über die aktivierte USB-Schnittstelle (280).

10. Verfahren nach Anspruch 9, ferner folgenden Schritt umfassend: Aktivieren (S50) der Haupteinheit aus einem inaktiven Zustand, wenn die USB-Schnittstelle (280) aktiviert wird (S40).

11. Verfahren nach Anspruch 10, ferner folgenden Schritt umfassend: Aktivieren (S60) einer Leistungsversorgung an eine Laufwerksteuerung (120), die in dem optischen Plattenlaufwerk (20) enthalten ist, wenn die Haupteinheit aktiviert wird (S50).

12. Verfahren nach einem der Ansprüche 9 bis 11, ferner folgende Schritte umfassend:
Auswerfen (S90) der optischen Platte (100) aus dem optischen Plattenlaufwerk (20), und
Deaktivieren (S 130) der USB-Schnittstelle (280) beim Auswerfen durch Öffnen (S 110) des Verbindungsschalters (260) unter Steuerung des Platteneinführschalters (110).

13. Verfahren nach Anspruch 12, wobei der Deaktivierungsschritt (S 130) um eine im Voraus festgelegte Auszeit (S 120) in Bezug auf den Schritt (S90) des Auswerfens der optischen Platte (100) verzögert wird.

14. Verfahren nach einem der Ansprüche 9 bis 13, wobei das optische Plattenlaufwerk (20) ferner eine Laufwerksteuerung (120) mit einer seriellen oder parallelen ATA-Schnittstelle (125) und eine Umwandlungseinheit (270) zur Signalumwandlung zwischen der seriellen oder parallelen ATA-Schnittstelle (125) und der USB-Schnittstelle (280) umfasst; wobei das Verfahren ferner folgende Schritte umfasst:
Empfangen (S500) eines Befehls zum Auswerfen einer optischen Platte (100) von der Haupteinheit über die USB-Schnittstelle (280), und
Umwandeln (S510) des Befehls in der Umwandlungseinheit (270) in ein Hardware-Auswurf-Signal (130) der seriellen oder parallelen ATA-Schnittstelle (125).

15. Verfahren nach einem der Ansprüche 9 bis 14, wobei das optische Plattenlaufwerk (20) ferner eine Laufwerksteuerung (120) mit einer seriellen oder parallelen ATA-Schnittstelle (125) und eine Umwandlungseinheit (270) zur Signalumwandlung zwischen der seriellen oder parallelen ATA-Schnittstelle (125) und der USB-Schnittstelle (280) umfasst; wobei das Verfahren ferner folgende Schritte umfasst:
Empfangen (S500) eines Befehls zur Hardware-Rücksetzung des optischen Plattenlaufwerks (20) von der Haupteinheit über die USB-Schnittstelle (280), und
Umwandeln (S510) des Befehls in der Umwandlungseinheit (270) in ein Hardware-Rücksetz-Signal (140) der seriellen oder parallelen ATA-Schnittstelle (125).

## Revendications

1. Lecteur de disque optique utilisé dans un véhicule, ledit lecteur de disque optique comprenant :
une interface USB (280) permettant de relier le lecteur de disque optique à une unité de tête ;
un commutateur d'entrée de disque (110) permettant de détecter l'insertion d'un disque optique (100) dans le lecteur de disque optique ;
un raccordement à une alimentation interne (265, 275) permettant de transmettre l'alimentation électrique provenant d'un connecteur d'alimentation (290) dudit lecteur de disque optique à ladite interface USB (280) ; et
un interrupteur de connexion (260) permettant de connecter et de déconnecter électriquement ladite connexion à l'alimentation interne (265, 275) ;
dans lequel ledit interrupteur de connexion (260) est commandé par ledit commutateur d'entrée de disque (110) de manière à activer ladite interface USB (280) lors de l'insertion d'un disque optique (100).

2. Lecteur de disque optique selon la revendication 1, comprenant en outre un contrôleur de lecture (120) comportant une interface ATA en série ou en parallèle (125) ; et
une unité de conversion (270) destinée à la conversion de signaux entre ladite interface ATA en série ou en parallèle (125) et ladite interface USB (280) ;
dans lequel ledit connecteur d'alimentation (290) est connecté à ladite unité de conversion (270) et où ladite connexion à l'alimentation interne (265, 275) connecte ladite unité de conversion (270) et ladite interface USB (280).

3. Lecteur de disque optique selon la revendication 1 ou 2, dans lequel ladite connexion à l'alimentation interne (265, 275) comprend une ligne (265) permettant d'obtenir une tension particulière prédéterminée aux bornes de ladite interface USB (280), et une ligne (275) reliée à la terre.

4. Lecteur de disque optique selon l'une quelconque des revendication 1 à 3, dans lequel ledit commutateur d'entrée de disque (110) commande en outre ledit interrupteur de connexion (260) de manière à désactiver ladite interface USB (280) lors de l'éjection du disque optique (100) du lecteur de disque optique.

5. Lecteur de disque optique selon la revendication 4, dans lequel ladite désactivation est retardée par un temps mort prédéterminé lors de l'éjection d'un disque optique (100).

6. Lecteur de disque optique selon l'une quelconque des revendication 2 à 5, dans lequel ladite unité de conversion (270) est en outre conçue pour convertir une commande d'éjection d'urgence d'un disque optique (100), reçue à partir de l'unité de tête par le biais de ladite interface USB (280) en un signal d'Ejection de matériel (130) de ladite interface ATA en série ou en parallèle (125).

7. Lecteur de disque optique selon l'une quelconque des revendication 2 à 6, dans lequel ladite unité de conversion (270) est en outre conçue pour convertir une commande destinée à lancer une réinitialisation de matériel dudit lecteur de disque optique, reçue depuis l'unité de tête par le biais de ladite interface USB (280), en un signal de Réinitialisation de matériel (140) de ladite interface ATA en série ou en parallèle (125).

8. Lecteur de disque optique selon l'une quelconque des revendication 2 à 7, dans lequel ladite unité de conversion (270) comprend un FPGA.

9. Procédé d'activation d'un lecteur de disque optique (20) utilisé dans un véhicule, dans lequel ledit lecteur de disque optique (20) est relié à une unité de tête par le biais d'une interface USB (280), ledit procédé comprenant les étapes suivantes :
l'introduction (S10) d'un disque optique (100) dans ledit lecteur de disque optique (20), activant ainsi (S20) un commutateur d'entrée de disque (110) en vue de détecter qu'un disque optique (100) est introduit dans le lecteur de disque optique (20),
la fermeture (S30) d'un commutateur de connexion (260) d'une connexion interne à l'alimentation (265, 275), afin d'acheminer une alimentation depuis un connecteur d'alimentation (290) dudit lecteur de disque optique (20) jusqu'à ladite interface USB (280), ledit interrupteur de connexion (260) étant commandé par ledit commutateur d'entrée de disque (110) ;
l'activation (S40) de ladite interface USB (280) par fermeture (S30) dudit interrupteur de connexion (260), et
le démarrage (S70) de la communication de données (285) entre ledit lecteur de disque optique (20) et ladite unité de tête par le biais de ladite interface USB (280) activée.

10. Procédé selon la revendication 9, comprenant en outre l'étape d'activation (S50) de ladite unité de tête à partir d'un état inactif, lors de l'activation (S40) de ladite interface USB (280).

11. Procédé selon la revendication 10, comprenant en outre l'étape d'activation (S60) d'une alimentation électrique vers un contrôleur de lecture (120) inclus dans ledit lecteur de disque optique (20) lors de l'activation (S50) de ladite unité de tête.

12. Procédé selon l'une quelconque des revendication 9 à 11, comprenant en outre les étapes
d'éjection (S90) du disque optique (100) à partir du lecteur de disque optique (20), et
la désactivation (S 130) de ladite interface USB (280) lors de l'éjection par ouverture (S110) dudit interrupteur de connexion (260) sous le contrôle dudit commutateur d'entrée de disque (110).

13. Procédé selon la revendication 12, dans lequel ladite étape de désactivation (S130) est retardée par un temps mort prédéterminé (S120) par rapport à l'étape (S90) d'éjection du disque optique (100).

14. Procédé selon l'une quelconque des revendication 9 à 13, dans lequel ledit lecteur de disque optique (20) comprend en outre un contrôleur de lecture (120) présentant une interface ATA en série ou en parallèle (125) et une unité de conversion (270) destinée à la conversion de signaux entre ladite interface ATA en série ou en parallèle (125) et ladite interface USB (280) ; ce procédé comprenant en outre les étapes suivantes
réception (S500) à partir de l'unité de tête, par l'intermédiaire de ladite interface USB (280), d'une commande d'éjection d'urgence d'un disque optique (100), et conversion (S510), dans ladite unité de conversion (270), de ladite commande en un signal d'Ejection de matériel (130) de ladite interface ATA en série ou en parallèle (125).

15. Procédé selon l'une quelconque des revendication 9 à 14, dans lequel ledit lecteur de disque optique (20) comprend en outre un contrôleur de lecture (120) présentant une interface ATA en série ou en parallèle (125) et une unité de conversion (270) destinée à la conversion de signaux entre ladite interface ATA en série ou en parallèle (125) et ladite interface USB (280) ; ce procédé comprenant en outre les étapes suivantes
réception (S500) à partir de l'unité de tête, par l'intermédiaire de ladite interface USB (280), d'une commande de réinitialisation de matériel dudit lecteur de disque optique (20), et
conversion (S510), dans ladite unité de conversion (270), de ladite commande en un signal de Réinitialisation de matériel (140) de ladite interface ATA en série ou en parallèle (125).
